# EUROPÄISCHE PATENTSCHRIFT

(11) **EP 2 065 115 B1**
(45) Veröffentlichungstag und Bekanntmachung des Hinweises auf die Patenterteilung: **23.02.2011**
(21) Anmeldenummer: 08000685.1
(22) Anmeldetag: 15.01.2008
(51) Int. Cl.: B23K 20/00, H01L 21/00, H01L 21/603, H01L 21/607, H01L 21/60

(54) **Verfahren zum Drahtbonden mit einem kupferhaltigen Bonddraht unter Verwendung zumindest zweier Plasmadüsen**
Method for bonding a wire containing copper with the use of at least two plasma nozzles
Procédé de soudage de fils contenant du cuivre avec utilisation d'au moins deux buses plasma

(30) Priorität: 29.11.2007 DE 102007057429
(43) Veröffentlichungstag der Anmeldung: 03.06.2009
(73) Patentinhaber: Linde AG, 80331 München (DE)
(72) Erfinder: Hiew, Pang Ling, Taman Oberseas Union Jalan Klang Lama (MY); Laumen, Christoph, 80634 München (DE); Tan, Boon Ann, 268059 Singapore (SG); Wandke, Ernst, 82538 Geretsried (DE)
(74) Vertreter: Gellner, Bernd

(56) Entgegenhaltungen:
- WO-A-2007/010510
- JP-A- 2000 340 599
- US-A- 4 976 393
- US-A1- 2007 001 320
- US-B1- 6 234 376

## Beschreibung

Die vorliegende Erfindung betrifft ein Verfahren zum Drahtbonden mit einem kupferhaltigen Bonddraht zur Verbindung eines Bauteils mit einem Träger gemäß dem Oberbegriff des Anspruchs 1 (siehe, z.B., WO 2007/010510 A).

Es sind eine Reihe von Verfahren und Vorrichtungen zum Drahtbonden bekannt. Das Drahtbonden stellt eine Verbindungstechnik dar, mittels derer Bauteile der Elektrotechnik, insbesondere mikroelektronische Komponenten oder nichtelektronische (Mikro-)Komponenten, unter Verwendung sehr dünner Drähte, der sog. Bonddrähte, mit elektrischen Anschlüssen versehen und/oder mit einem Chip verbunden werden.

Bei den bekannten Verfahren wird als Bonddraht meist ein Golddraht oder eine Goldlegierung eingesetzt. Darüberhinaus finden Aluminiumdraht und auch Kupferdraht Verwendung.

Beim Einsatz von Kupferdraht oder kupferhaltigem Bonddraht haben sich in der Vergangenheit jedoch Schwierigkeiten gezeigt, die durch dort anlagernde Oxide begründet zu sein scheinen. Kupfer ist in der Regel zumindest leicht oxidiert. Die Leitfähigkeit eines kupferhaltigen Bonddrahtes und die Verbindungsfestigkeit einer Bondverbindung sind durch die Anwesenheit der Oxide reduziert.

Das Dokument US 6,234,376 offenbart ein Verfahren und eine Vorrichtung zum Drahtbonden unter Einsatz eines Schutzgases, welches die Oxidbildung vermindern und so den Einsatz von Kupfer- oder Aluminiumdraht als Bonddraht ermöglichen soll.

Im Weiteren soll der Begriff kupferhaltiger Bonddraht sowohl reinen Kupferdraht wie auch Drahtlegierungen mit einem Kupfergehalt von mindestens 10% umfassen. Aufgabe der vorwiegenden Erfindung ist es ein verbessertes Verfahren zum Drahtbonden mit einem kupferhaltigen Bonddraht zur Verfügung zu stellen.

Ein Verfahren gemäss der Erfindung ist im Anspruch 1 definiert.

Durch die Anwesenheit des Plasmas findet vorteilhafterweise eine Reduktion und Aktivierung der Bonddraht- und Bondpad-Oberfläche statt. Die Partner der Verbindungstechnik, die mit dem Plasma beaufschlagt sind, werden gereinigt und ihre Oberfläche wird aktiviert. Dies führt vorteilhaft zu besonders guten Ergebnissen beim Drahtbonden. Die Anwesenheit des Plasmas kann also vorhandene Oxide des für die Verbindung mit dem Bondpad vorgesehenen Teils des Bonddrahtes (des angeschmolzenen Teils des Bonddrahtes) und/oder des Bondpads und/oder des Bondraums reduzieren und deren Neubildung weitgehend verhindern und so eine von Oxiden weitgehend freie Verbindung von hoher Qualität und Zuverlässigkeit ermöglichen.

Bevorzugt ist die Plasmadüse so angebracht, dass der für die Verbindung mit dem Bondpad vorgesehene, angeschmolzene Teil des Bonddrahtes mit dem Plasma beaufschlagt wird. Gemäß einer vorteilhaften Weiterbildung des erfindungsgemäßen Verfahrens wird die zweite Plasmadüse so angebracht, dass der Bondpad mit dem Plasma beaufschlagt wird.

Die erste Plasmadüse wird erfindungsgemäß in ihrer Ausrichtung zielorientiert eingestellt, so dass ein sie verlassender Plasmastrahl auf einen vorab ausgewählten Bereich als Ziel trifft. Besonders vorteilhafte Bereiche bzw. Komponenten der Vorrichtung wurden bereits genannt. Die Plasmadüse kann als Düsenpaar ausgebildet sein. Auch eine Ausgestaltung mit z.B. 3, 4, 5 oder einer Vielzahl von Düsen nebeneinander, als sog. Düsenbündel, hat sich für bestimmte Fälle als zweckmäßig erwiesen. Die Plasmadüse(n) kann/können auch mit besonderem Vorteil zur Auffächerung des Plasmastrahls mehrere Austrittsöffnungen aufweisen.

Für die vorliegende Erfindung konnten die folgenden Plasmakomponenten als besonders vorteilhaft ermittelt werden: Wasserstoff, Argon und Mischungen daraus sowie Mischungen aus Wasserstoff mit Stickstoff, auch mit weiterem Zusatz von Argon.

Das Plasma wird vorzugsweise bei Atmosphärendruck erzeugt. Dies hat den Vorteil, dass eine spezielle Kammer, in der das Plasma erzeugt wird, nicht zwingend notwendig ist. Es ist aber ebenso möglich, ein Niederdruckplasma, beispielsweise bei einem Druck von weniger als 10 mbar, ausgebildet wird.

Gemäß der Erfindung ist also die Plasmadüse in ihrer Ausrichtung verstellbar ausgeführt, so dass auf diese Weise ermöglicht wird, dass ein sie verlassender Plasmastrahl auf einen vorab einstellbaren Bereich als Ziel trifft.

Gemäß einer weiteren vorteilhaften Ausgestaltung der Erfindung ist die Plasmadüse in dem Bereich angebracht, in dem der Bonddraht die Führung verlässt. Somit ist z.B. der Plasmastrahl auf den Bonddraht gerichtet. Bevorzugt ist der Plasmastrahl senkrecht auf die Längsrichtung des Bonddrahtes gerichtet.

Gemäß der Erfindung ist eine zweite Plasmadüse vorgesehen. Diese zweite Plasmadüse ist so ausgerichtet, dass sie einen anderen Bereich als die erste beaufschlagt.

Die Plasmadüse ist beispielsweise mit einer Plasmaerzeugungseinheit verbunden, die ihrerseits mit einer Gasversorgung in Verbindung steht, wobei die Plasmaerzeugungseinheit mindestens zwei Elektroden aufweist, zwischen denen eine elektrische Entladung herbeigeführt werden kann mit deren Hilfe in dem über die Gasversorgung zur Verfügung gestellten Prozessgas ein Plasma erzeugt wird.

Gemäß einer besonders bevorzugten Ausführungsform der Erfindung ist die zweite Plasmadüse auf den Bondpad gerichtet, insbesondere senkrecht auf den Bondpad gerichtet. Durch diese Ausgestaltung werden die beschriebenen positiven Effekte des Plasmas besonders ausgeprägt erzielt.

Die vorliegende Erfindung eignet sich für das Drahtbonden im allgemeinen und besonders für das Ballbonden und auch für das Wedgebonden.

Als Beispiel sei hier zunächst eine für das Ballbonden geeignete Ausgestaltung der Erfindung näher beschrieben: Beim Ballbonden ist eine Vorrichtung zum Drahtbonden mit einer Führung für den Bonddraht vorgesehen, die als Kapillare ausgebildet ist und einen Kapillarkopf aufweist, durch die der Bonddraht geführt wird. Desweiteren weist die Vorrichtung ein Rohr zur Aufnahme einer Gasatmosphäre auf, das eine erste und zweite Öffnung aufweist, wobei die beiden Öffnungen in einer zur Achse des Rohres transversalen Richtung übereinander zur Deckung gebracht werden können, und wobei zumindest die Spitze des Kapillarkopfs durch die Öffnungen geführt werden kann. Außerdem ist eine Einrichtung zum Anschmelzen des aus der Spitze des Kapillarkopfs herausragenden Endes des Bonddrahtes vorgesehen, so dass dieses Ende des Bonddrahtes kugelartig geformt wird und mit dem Durchführen zumindest der Spitze des Kapillarkopfes mit einem Bondpad in Berührung gebracht werden kann.

Im Rahmen dieses Beispiels ist es besonders vorteilhaft, wenn die Plasmadüse parallel zur Achse des Rohres im Rohr angebracht ist. Alternativ kann die Plasmadüse gegen die Achse des Rohres geneigt im Rohr angebracht sein, insbesondere so geneigt, dass die Strahlrichtung des die Plasmadüse verlassenden Plasmastrahls auf den Bondpad zeigt. Gemäß einer besonders bevorzugten Weiterbildung kann die Plasmadüse so ausgebildet und angebracht sein, dass ein mit dem Plasmastrahl beaufschlagter Bereich das Ende des Bonddrahts und den Flammenaustritt der Einrichtung zum Anschmelzen des aus der Spitze des Kapillarkopfs herausragenden Endes des Bonddrahtes umfasst. Vorteilhafte Ausgestaltungen der Einrichtung zum Anschmelzen des Bonddrahtes werden später noch beschrieben.
Als weiteres Beispiel sei eine für das Wedgebonden geeignete Ausgestaltung der Erfindung näher beschrieben: Beim Wedgebonden wird der Bonddraht ebenfalls mit einer Kapillare oder mit einem Bondwedge geführt. Es ist jedoch nicht die Ausbildung eines kugelartigen, angeschmolzenen Endes des Bonddrahtes vorgesehen, sondern der Bonddraht wird an irgendeiner wählbaren Stelle angeschmolzen und dann mit dem Bondpad in Berührung gebracht.

Besonders vorteilhaft ist für viele Anwendungen eine Kombination aus Ball- und Wedgebonden, bei der eine erste Verbindung als Ballbond und eine zweite Verbindung als Wedgebond ausgeführt sind.

Die Führung für den Bonddraht ist bevorzugt bewegbar ausgebildet, besonders bevorzugt vertikal und/oder horizontal bewegbar.

Für die vorliegende Erfindung haben sich eine Reihe von Einrichtungen zum Anschmelzen des Bonddrahtes als geeignet erwiesen. Beispielshaft seien im Folgenden zwei Möglichkeiten herausgegriffen und näher beschrieben:

Als Einrichtung zum Anschmelzen des Bonddrahtes kann eine EFO -Einrichtung (electric flame off device) vorgesehen sein, die eine Elektrode aufweist, die so angebracht ist, dass sie eine elektrische Lichtbogenentladung ermöglicht.

Als Einrichtung zum Anschmelzen des Bonddrahtes kann alternativ eine wasserstoffreiche Wasserstoff-Sauerstoff-Flamme dienen, die so ausgebildet ist, dass sie den für eine Verbindung mit einem Bondpad vorgesehenen Teil des Bonddrahts erhitzt und anschmilzt. Im Falle eines Ballbonds soll dabei das Ende des Bonddrahtes kugelförmig verformt werden.

Zur Erzeugung des aus der Plasmadüse austretenden Plasmas steht vorteilhafterweise eine Plasmaerzeugungseinheit zur Verfügung, die beispielsweise folgende Komponenten aufweist: Eine Gasversorgung für die Plasmaerzeugung, die mit je einem Reservoir für Wasserstoff und/oder Argon und/oder Stickstoff in Verbindung steht. Gegebenenfalls kann eine Mischeinheit zum Vormischen einer gewünschten Zusammensetzung zweckmäßig sein. Der Zufluss an Prozessgas über die Gasversorgung ist bevorzugt beschränkt, insbesondere gedrosselt. Besonders bevorzugt ist ein Gesamtdurchfluss von weniger als 3 m³ pro Stunde vorgesehen. Die Plasmaerzeugungseinheit ist dabei einerseits mit der Plasmadüse und andererseits mit der Gasversorgung verbunden, wobei die Plasmaerzeugungseinheit mindestens zwei Elektroden aufweist, zwischen denen eine elektrische Entladung herbeigeführt und in einem über die Gasversorgung zur Verfügung gestellten Prozessgas ein Plasma erzeugt wird.

Gemäß einer sehr vorteilhaften Weiterbildung der Erfindung ist beispielsweise eine Plasmatemperatur von bis zu 200°C angestrebt. Besonders günstig hat sich eine Temperatur im Bereich von 80 bis 120°C erwiesen.

Zum Anschmelzen des Bonddrahtes sowie zur Erzeugung des Plasmas wird beispielhaft auf die bereits geschilderten Möglichkeiten der Ausgestaltung verwiesen.

Die vorliegende Erfindung eignet sich für Ballbond- und für Wedgebondverfahren bzw. Verfahrensschritte. Die Erfindung kann auch bei zusammengesetzten Bondverfahren eingesetzt werden, die jeweils Verfahrensschritte des Ball- und des Wedgebondens aufweisen.

Die vorliegende Erfindung weist eine ganze Reihe von Vorteilen auf, von denen z.B. eine Erhöhung der Zuverlässigkeit und Gleichbleiben der Qualität der Verbindung hier nochmal genannt werden sollen.

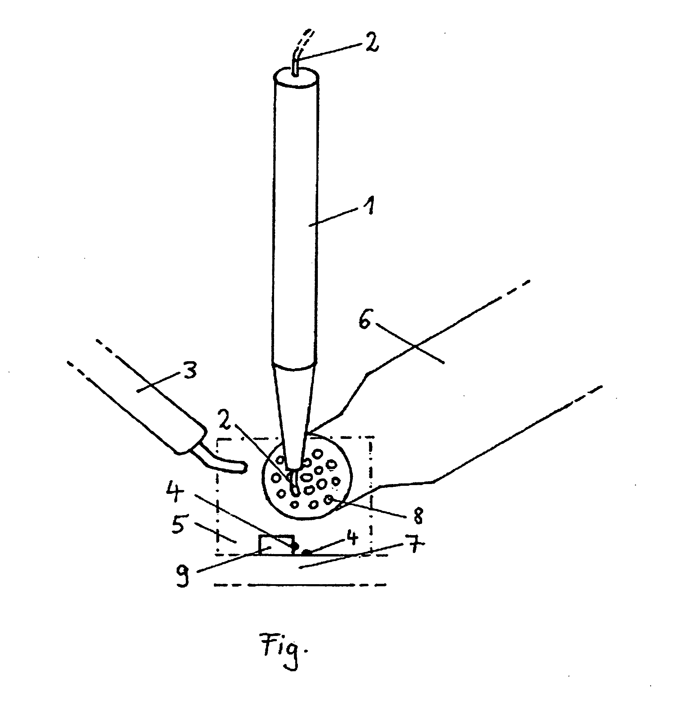

Die Figur zeigt: eine Vorrichtung zum Drahtbonden, die nicht Gegenstand der Erfindung ist.

Im Einzelnen zeigt die Figur eine Führung 1 für einen kupferhaltigen Bonddraht 2 und eine Einrichtung 3 zum Anschmelzen eines für eine Verbindung mit einem Mikrochip 9 vorgesehenen Teils eines Bonddrahtes 2. Der Mikrochip 9 ist mit einemTräger 7 als Unterlage zu verbinden. Der Träger 7 kann beispielsweise als Leiterplatte 7 ausgebildet sein. Auf beiden Bauteilen, Mikrochip 9 und Träger 7, befinden sich Bondpads 4, die beim Bonden durch feine Drähte, Bonddraht 2, verbunden werden.

Die Führung 1 für den Bonddraht 2 ist so ausgebildet, dass der angeschmolzene Teil des Bonddrahtes 2 in einem Bondraum 5 mit einem Bondpad 4 in Berührung gebracht wird. Eine Plasmadüse 6 ist vorgesehen, mit deren Hilfe der für die Verbindung mit dem Bondpad 4 des Mikrochips 9 vorgesehene Teil des Bonddrahtes 2 mit Plasma beaufschlagt wird. Die Plasmadüse 6 weist hier zur Auffächerung des Plasmastrahls mehrere Austrittsöffnungen 8 auf. Die Führung 1 ist vertikal bewegbar ausgebildet und kann zum Verbinden des Bonddrahtes mit den Bondpads 4 abgesenkt werden.

## Patentansprüche

1. Verfahren zum Drahtbonden mit einem kupferhaltigen Bonddraht (2) zur Verbindung eines Bauteils (9) mit einem Träger (7), wobei sowohl am Bauteil (9) als auch am Träger (7) je mindestens ein Bondpad (4) vorgesehen ist, bei dem der Bonddraht (2) unter Einsatz einer Führung (1) mit einer Einrichtung (3) zum Anschmelzen des Bonddrahtes (2) in Wirkverbindung gebracht wird, so dass ein für eine Verbindung mit einem der Bondpads (4) vorgesehener Teil des Bonddrahtes (2) angeschmolzen wird, und der angeschmolzene Teil des Bonddrahtes (2) in einem Bondraum (5) mit mindestens je einem Bondpad (4) in Berührung gebracht und mit diesem verbunden wird, wobei zumindest eine erste und eine zweite Plasmadüse (6) eingesetzt werden, wobei mit Hilfe der ersten und der zweiten Plasmadüse der für die Verbindung mit dem Bondpad (4) vorgesehene Teil des Bonddrahtes (2) und/oder der Bondpad (4) und/oder der Bondraum (5) mit einem Plasma beaufschlagt wird, und wobei die erste Plasmadüse (6) in ihrer Ausrichtung zielgerichtet eingestellt wird, so dass ein vorab ausgewählter Bereich als Ziel mit dem Plasma beaufschlagt wird, **dadurch gekennzeichnet, dass** die zweite Plasmadüse so ausgerichtet ist, dass sie einen anderen Bereich als die erste Plasmadüse beaufschlagt.

2. Verfahren nach Anspruch 1, **dadurch gekennzeichnet, dass** eine der Plasmadüsen (6) so eingestellt wird, dass die Einrichtung (3) zum Anschmelzen des Bonddrahtes mit einem Plasma beaufschlagt wird.

3. Verfahren nach Anspruch 1 oder 2, **dadurch gekennzeichnet, dass** mehr als zwei Plasmadüsen (6), bevorzugt 3, 4 oder 5 Plasmadüsen, eingesetzt werden und/oder eine oder mehrere Plasmadüse(n) eingesetzt werden, die jeweils mehrere Austrittsöffnungen aufweisen.

4. Verfahren nach einem der Ansprüche 1 bis 3, **dadurch gekennzeichnet, dass** ein die zweite Plasmadüse (6) verlassender Plasmastrahl auf den Bondpad (4) gerichtet wird, insbesondere senkrecht auf den Bondpad (4) gerichtet wird.

## Claims

1. Method for wire bonding with a copper-containing bonding wire (2) for connecting a component (9) to a carrier (7), wherein at least one respective bonding pad (4) is provided both on the component (9) and on the carrier (7), in which method a guide (1) is used to bring the bonding wire (2) into operative connection with a device (3) for fusing on the bonding wire (2), so that a part of the bonding wire (2) that is intended for a connection to one of the bonding pads (4) is fused on, and the fused-on part of the bonding wire (2) is brought into contact with at least one respective bonding pad (4) in a bonding space (5) and is connected to said pad, wherein at least a first and a second plasma nozzle (6) are used, wherein, with the aid of the first and second plasma nozzles, the part of the bonding wire (2) that is intended for the connection to the bonding pad (4) and/or the bonding pad (4) and/or the bonding space (5) is exposed to a plasma, and wherein the first plasma nozzle (6) is set specifically in its alignment such that a previously selected region is exposed to the plasma as a target, **characterized in that** the second plasma nozzle is aligned such that it exposes a different region than the first plasma nozzle.

2. Method according to Claim 1, **characterized in that** one of the plasma nozzles (6) is set such that the device (3) for fusing on the bonding wire is exposed to a plasma.

3. Method according to Claim 1 or 2, **characterized in that** more than two plasma nozzles (6), preferably 3, 4 or 5 plasma nozzles, are used and/or one or more plasma nozzles, which each have a number of outlet openings, are used.

4. Method according to one of Claims 1 to 3, **characterized in that** a plasma jet leaving the second plasma nozzle (6) is directed onto the bonding pad (4), in particular is directed perpendicularly onto the bonding pad (4).

## Revendications

1. Procédé de soudage avec un fil de soudage contenant du cuivre (2) pour l'assemblage d'un composant (9) avec un support (7), dans lequel il est prévu aussi bien sur le composant (9) que sur le support (7) chaque fois au moins une pastille de soudage (4), dans lequel on amène le fil de soudage (2) en liaison active avec un dispositif (3) pour fondre le fil de soudage (2) en utilisant un guidage (1), de telle manière qu'une partie du fil de soudage (2) prévue pour un assemblage avec une des pastilles de soudage (4) soit fondue, et on met la partie fondue du fil de soudage (2) respectivement en contact avec au moins une pastille de soudage (4) dans un espace de soudage (5) et on l'assemble à celle-ci, dans lequel on utilise au moins une première et une deuxième buses à plasma (6), dans lequel on expose à un plasma, à l'aide de la première et de la deuxième buses à plasma, la partie du fil de soudage (2) prévue pour l'assemblage avec la pastille de soudage (4) et/ou la pastille de soudage (4) et/ou l'espace de soudage (5), et dans lequel on règle la première buse à plasma (6) en son alignement en direction de la cible, de telle manière qu'une zone préalablement sélectionnée comme cible soit exposée au plasma, **caractérisé en ce que** la deuxième buse à plasma est orientée de telle manière qu'elle atteigne une autre zone que la première buse à plasma.

2. Procédé selon la revendication 1, **caractérisé en ce que** l'on règle une des buses à plasma (6) de telle manière que le dispositif (3) pour fondre le fil de soudage soit atteint par un plasma.

3. Procédé selon la revendication 1 ou 2, **caractérisé en ce que** l'on utilise plus de deux buses à plasma (6), de préférence 3, 4 ou 5 buses à plasma, et/ou on utilise une ou plusieurs buse(s) à plasma, qui présentent chacune plusieurs ouvertures de sortie.

4. Procédé selon l'une quelconque des revendications 1 à 3, **caractérisé en ce que** l'on oriente un jet de plasma quittant la deuxième buse à plasma (6) vers la pastille de soudage (4), en particulier on l'oriente perpendiculairement vers la pastille de soudage (4).
